**Europäisches Patentamt**

**European Patent Office**

**Office européen des brevets**

(19)

(11) Veröffentlichungsnummer : **0 095 706**
**B1**

# EUROPÄISCHE PATENTSCHRIFT

(12)

(45) Veröffentlichungstag der Patentschrift :
01.10.86

(21) Anmeldenummer : 83105129.7

(22) Anmeldetag : 24.05.83

(51) Int. Cl.⁴ : **H 03 K 19/177, G 01 R 31/28**

(54) Programmierbare Logikanordnung in ECL-Technik.

(30) Priorität : 28.05.82 DE 3220302

(43) Veröffentlichungstag der Anmeldung :
07.12.83 Patentblatt 83/49

(45) Bekanntmachung des Hinweises auf die Patenterteilung : 01.10.86 Patentblatt 86/40

(84) Benannte Vertragsstaaten :
AT CH DE FR GB IT LI NL

(56) Entgegenhaltungen :
EP-A- 0 061 602
IBM TECHNICAL DISCLOSURE BULLETIN, Band 18,
Nr. 19, März 1976, J.R. CAVALIERE et al. "Current
switch read-only programmable logic array", Seiten
3245-3248
ELECTRONIC DESIGN, Band 29, Nr. 4, 19. Februar
1981 "Design prototypes quickly with programmable
arrays", Seiten 121-124
IBM TECHNICAL DISCLOSURE BULLETIN, Band 22,
Nr. 5, Oktober 1979 W.W. SU "Pretesting laserable
PLA peripheral circuits", Seiten 1866-1869

(73) Patentinhaber : Siemens Aktiengesellschaft Berlin
und München
Wittelsbacherplatz 2
D-8000 München 2 (DE)

(72) Erfinder : Barré, Claude, Dipl.-Ing.
Implerstrasse 23
D-8000 München 70 (DE)

**Beschreibung**

Die Erfindung bezieht sich auf eine programmierbare Logikanordnung in ECL-Technik nach dem Oberbegriff des Patentanspruchs 1 und ein Verfahren zu ihrer Prüfung im nicht programmierten Zustand.

Programmierbare Logikanordnungen (PLA) sind in vielfältigen integrierten Ausführungen hinsichtlich ihres allgemeinen logischen Konzepts und der Wahl der Verknüpfungselemente bekannt (vergl. « Electronic Design », 29 (1981), H. 4, Seiten 121 bis 124). Jede programmierbare Logikanordnung enthält zwei Matrizen. Die Eingangsvariablen steuern über nicht invertierende und invertierende Verstärker die Potentiale auf den paarweise vorhandenen Eingangsleitungen der UND- bzw. Produktmatrix. Im Endzustand der Logikanordnung sind an entsprechend der Programmierung ausgewählten Kreuzungsstellen der Eingangsleitungen mit Produkttermleitungen Koppelelemente wirksam, mit deren Hilfe logische Verknüpfung von nichtinvertierten und/oder invertierten Eingangssignalen ausgeführt werden.

Die Produkttermleitungen bilden, gegebenenfalls unter Zwischenschaltung von Invertern, die Eingangsleitungen der ODER- bzw. Summenmatrix. Auch hier sind nur an den gemäß der Programmierungsvorschrift ausgewählten Kreuzungsstellen der Eingangsleitungen mit Summentermleitungen Koppelelemente wirksam, die nicht zwangsläufig gleich den Koppelelementen in der Produktmatrix sein müssen. An die Summentermleitungen sind im allgemeinen nichtinvertierende oder invertierende Verstärker angeschlossen, an deren Ausgängen die Verknüpfungsergebnisse der programmierbaren Logikanordnung zur Verfügung stehen. Eine solche programmierbare Logikanordnung in ECL-Technik ist durch die Europäische Patentanmeldung EP-A-0025102 bekannt.

Bei der Herstellung von programmierbaren Logikanordnungen werden im allgemeinen Koppelelemente an allen vorkommenden Kreuzungsstellen in beiden Matrizen angeordnet und über trennbare Verbindungen (fusible links) an die sich kreuzenden Matrixleitungen angeschlossen. Erst wenn ein bestimmer Anwendungsfall festliegt, d. h. die gewünschten logischen Verknüpfungsfunktionen bezüglich aller Ausgänge bekannt sind, wird durch die « Programmierung » beim Hersteller oder beim Anwender ein Teil der Koppelelemente durch Zerstörung der trennbaren Anschlußverbindungen unwirksam gemacht. Auch Fehler, die schon in der unprogrammierten Anordnung vorlagen, sind erst jetzt durch eine Prüfung der logischen Funktionen erkennbar.

Obgleich der Einsatz von programmierbaren Logikanordnungen in hervorragender Weise die Möglichkeit bietet, in Grenzen beliebige logische Verknüpfungen ohne spezielle Anpassung der Integrationsmasken an die jeweiligen Erfordernisse zu realisieren, darf nicht übersehen werden, daß der Programmiervorgang doch noch einen relativ aufwendigen Schritt bis zur endgültigen Fertigstellung der Logikanordnung darstellt. Es wäre also wünschenswert, eine programmierbare Logikanordnung schon vor der Programmierung zu prüfen. Dem stehen jedoch folgende Gegebenheiten entgegen :

a) Die Ausgänge der Produktmatrix sind als interne Leitungen nicht kontaktierbar. Das gleiche trifft häufig auch auf die Ausgänge der Summenmatrix zu, wenn nämlich auf die programmierbare Logikanordnung innerhalb eines integrierten Bausteines weitere Schaltungsanordnungen folgen.

b) Sowohl die nichtinvertierenden als auch die invertierenden Ausgänge aller Eingangsverstärker sind mit allen Produkttermleitungen gekoppelt, so daß Änderungen der Binärwerte der Eingangsvariablen auf die Potentiale der Produkttermleitungen nicht durchgreifen.

c) alle Produkttermleitungen sind mit allen Summentermleitungen gekoppelt, so daß sich einzelne fehlerhafte oder nicht vollständig angeschlossene Koppelelemente nicht bemerkbar machen.

Aus « IBM Technical Disclosure Bulletin, Vol. 22, No. 5, Oktober 1979, Seiten 1866 bis 1869 » ist bereits eine programmierbare und vor der Programmierung prüfbare Logikanordnung bekannt, die zum Zweck der Prüfung verschiedene zusätzliche Elemente enthält. So sind zum Beispiel alle Eingangsleitungen der Produktmatrix zusätzlich jeweils mit zwei den Ausgangsleitungen entsprechenden Testleitungen über Koppelelemente verbunden, die über Inverter in den Eingangsleitungen der Summenmatrix entsprechende Anschlußleitungen übergehen, die wiederum jeweils mit allen Ausgangsleitungen der Summenmatrix über Koppelelemente verbunden sind, so daß die Reihenschaltung aus den Spaltenleitungen beider Matrizen überprüft werden kann. Um weiterhin die zwischen beiden Matrizen vorhandenen Inverter und die Zeilenleitungen beider Matrizen prüfen zu können, sind die Reihenschaltungen der Zeilenleitungen jeweils an den Kathoden von Dioden angeschlossen, deren Anoden mit einer gemeinsamen Testausgangsleitung verbunden sind, während die einzelnen Zeilenleitungen eingangsseitig mit einer Testeingangsleitung verbunden sind, über die wahlweise ein Spannungspegel für die logischen Binärzustände « 0 » und « 1 » anschaltbar ist. Bei intakter Logikanordnung nimmt die Testausgangsleitung den logischen Binärwert « 1 » an, wenn an die Testeingangsleitung der logische Binärwert « 0 » angelegt wird.

Der Erfindung liegt die Aufgabe zugrunde, eine auf der Grundlage der ECL-Technik ausgeführte programmierbare Logikanordnung mit nur geringem zusätzlichen Aufwand so auszubilden, daß ihre vollständige Prüfung vor der Programmierung möglich ist, und ein Verfahren zu ihrer Prüfung anzugeben.

Gemäß der Erfindung weist eine solche Logikanordnung die Merkmale im kennzeichnenden Teil des Patentanspruchs 1 auf. Prüfungsverfahren sind den Ansprüchen 2 und 3 zu entnehmen.

Einzelheiten der Erfindung werden im folgenden anhand der Zeichnung beschrieben. Es zeigt darin :

Figur 1 eine vereinfachte Darstellung einer programmierbaren Logikanordnung gemäß der Erfindung,

Figur 2 eine Variante der Anordnung der Koppelelemente in der Produktmatrix,

Figur 3 die Schaltungsanordnung eines Eingangsverstärkers.

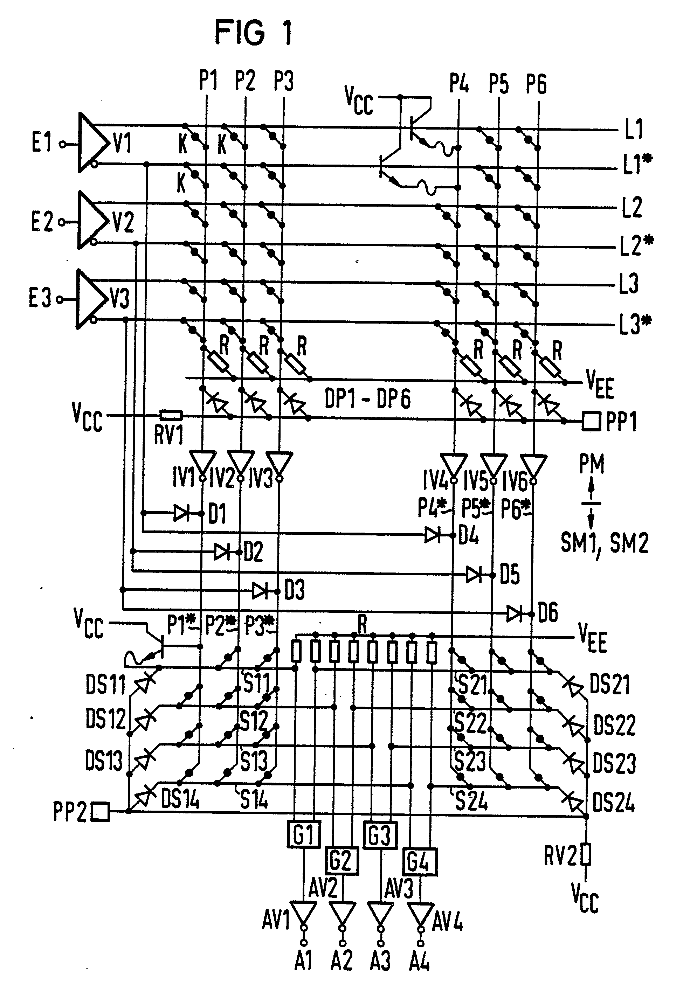

Die programmierbare Logikanordnung nach Fig. 1 besitzt drei Eingänge E1 bis E3 für die gleichnamigen Eingangsvariablen. Drei Eingangsverstärker V1 bis V3 in ECL-Technik weisen jeweils einen nichtinvertierenden und einen invertierenden Ausgang auf. An die Verstärkerausgänge sind die Eingangsleitungen L1, L1* bis L3, L3* der Produktmatrix PM mit sechs Produkttermleitungen P1 bis P6 angeschlossen. Die Produkttermleitungen P1 bis P6 enden in sechs Produktterminvertern IV1 bis IV6, deren Ausgänge mit Eingangsleitungen P1* bis P3* und P4* bis P6* für zwei getrennte Summenteilmatrizen SM1 und SM2 verbunden sind. Die Summenteilmatrizen SM1 und SM2 enthalten je vier Summentermleitungen S11 bis S14 und S21 bis S24, die paarweise mit den Eingängen von Verknüpfungsgliedern G1 bis G4 verbunden sind. An die Ausgänge der Verknüpfungsglieder G1 bis G4 sind invertierende Ausgangsverstärker AV1 bis AV4 angeschlossen. Die Ausgänge dieser Verstärker bilden die Ausgänge A1 bis A4 der programmierbaren Logikanordnung.

Als Koppelelemente K sind in der Anordnung nach Fig. 1 Bipolartransistoren in Emitterfolgerschaltung eingesetzt. Zur Vereinfachung der Zeichnung sind in Fig. 1 nur die Koppelelemente an den Kreuzungsstellen der Eingangsleitungen L1 und L1* mit der Produkttermleitung P4 in der Produktmatrix PM und an der Kreuzungsstelle der Eingangsleitung P1* mit der Summentermleitung S11 in der Summenteilmatrix SM1 ausführlich dargestellt. An allen anderen Kreuzungspunkten sind die Koppelelemente K nur symbolisch durch einen Punkt angedeutet, der über diagonale Verbindungen an die sich kreuzenden Leitungen angeschlossen ist. Alle Produkt- und Summentermleitungen sind über Widerstände R mit dem emitterseitigen Betriebsspannungsanschluß $V_{EE}$ verbunden. Die Widerstände R dienen als gemeinsame Emitterwiderstände für die als Koppelelemente eingesetzten, jeweils einer der genannten Leitungen zugeordneten Emitterfolger.

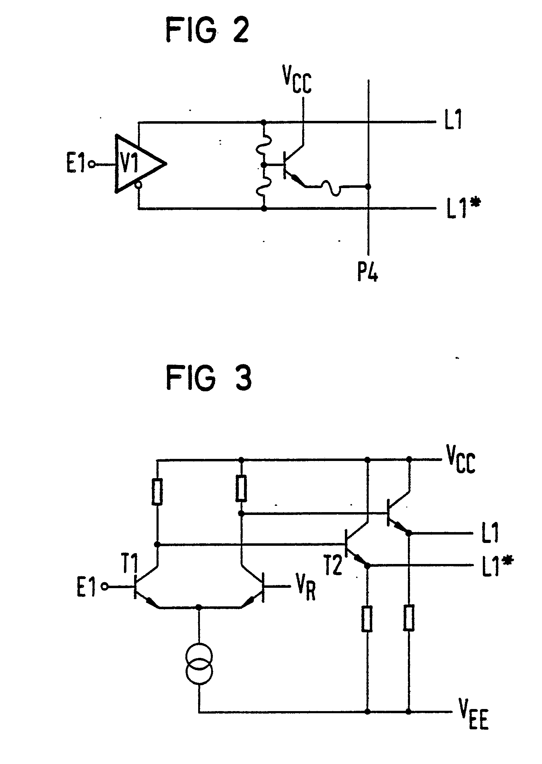

Da bei einer fertig programmierten Logikanordnung an den beiden Kreuzungsstellen einer Produkttermleitung, z. B. P1, mit den zueinander inverse Steuersignale führenden Eingangsleitungen, z. B. L1 und L1*, in der Produktmatrix höchstens noch eine Kreuzungsstelle mit einem wirksamen Koppelelement besetzt ist, können die zwei aus Fig. 1 ersichtlichen Emitterfolger durch eine Schaltungsanordnung nach Fig. 2 mit nur einem Emitterfolger ersetzt werden.

Dies hat zur Folge, daß im unprogrammierten Zustand die nichtinvertierenden und die invertierenden Ausgänge der Eingangsverstärker V1 bis V3 galvanisch verbunden sind. Der Kurzschluß der Verstärkerausgänge ist jedoch auch bei einer Inbetriebnahme der unprogrammierten Logikanordnung unschädlich. Das ist aus Fig. 3, die einen Eingangsverstärker in ECL-Technik in bekannter Ausführung zeigt, ohne weiteres ersichtlich. Der jeweils von dem einen Ausgangstransistor gelieferte höhere Ausgangspegel setzt sich durch, der andere Ausgangstransistor wird gesperrt.

Außer den bisher beschriebenen Einrichtungen enthält die Anordnung nach Fig. 1 noch einige weitere Einrichtungen, die nachstehend näher behandelt werden. Sie dienen neben der schon erwähnten Aufteilung der Summenmatrix dazu, die programmierbare Logikanordnung prüfbar zu machen.

Zwischen einer von einem Prüfanschluß PP1 ausgehenden Prüfleitung und allen Produkttermleitungen P1 bis P6 sind Dioden DP1 bis DP6 so eingefügt, daß ihre Anoden mit der Prüfleitung verbunden sind. Ein an den kollektorseitigen Betriebsspannungsanschluß $V_{CC}$ und die Prüfleitung angeschlossener Widerstand RV1 erzeugt einen geringen Vorstrom für die Dioden DP1-DP6. Da der Widerstand RV1 nur während der Prüfung benötigt wird, muß er nicht auf dem Bausteinchip integriert sein.

In gleicher Weise sind zwischen einem zweiten Prüfanschluß PP2 und allen Summentermleitungen S11 bis S24 Dioden DS11 bis DS24 vorgesehen. Auch für den zugehörigen Vorwiderstand RV2 gilt das gleiche wie für den Vorwiderstand RV1.

Zur Prüfung der Produktmatrix wird zunächst an alle Variableneingänge E1 bis E3 ein Pegel M (— 1,2 V) angelegt, der in der Mitte zwischen den normalen binären Signalpegeln H (— 0,8 V) und L (— 1,6 V) liegt. Am Prüfanschluß PP1 ist dann ein dem Mittelpegel M entsprechender Pegel zu messen. Nun wird nacheinander jeweils an einen Variableneingang der hohe binäre Signalpegel H angelegt. Am Prüfanschluß PP1 stellt sich gleichfalls ein höherer Pegel ein, doch nur, wenn die mit den nichtinvertierenden Verstärkerausgängen verbundenen Koppelelemente und ihre Anschlußverbindungen in Ordnung sind. Bei einer Anordnung der Koppelelemente nach Fig. 1 werden in einem zweiten Durchgang, bei dem nacheinander der niedere binäre Signalpegel L an die Eingänge E1 bis E3 angelegt wird, die an den invertierenden Ausgängen der Verstärker angeschlossenen Koppelelemente überprüft. Der am Prüfanschluß PP1 anliegende Pegel ist bei Fehlerfreiheit der Matrix gleichfalls hoch.

Bei einer Ausbildung der Produktmatrix gemäß Fig. 2 wäre im Hinblick auf die Überprüfung der Koppelelemente der zweite Durchgang überflüssig. Es empfiehlt sich dennoch, ihn auszuführen, da auch einzelne der trennbaren Verbindungen, die zunächst die beiden Verstärkerausgänge überbrücken, unterbrochen sein könnten.

Da die Prüfung der Summenmatrix analog zur Prüfung der Produktmatrix nur möglich ist, wenn die Pegel auf den Eingangsleitungen individuell steuerbar sind, sind weitere Dioden D1 bis D6 an die invertierenden Ausgängen $\overline{Va1}$ bis $\overline{Va3}$ der Eingangsverstärker V1 bis V3 einerseits und an die Eingangsleitungen P1* bis P6* der Summenmatrix andererseits angeschlossen (Fig. 1). Die Anschaltung erfolgt so, daß die erste Eingangsleitung P1* mit dem ersten Verstärker V1, die zweite Eingangsleitung P2* mit dem zweiten Verstärker V 2 usw. verbunden ist, bis entweder alle Eingangsleitungen oder alle Verstärker erfaßt sind. Ist die Zahl der Eingangsleitungen der Summenmatrix größer als die Zahl der Variableneingänge bzw. Eingangsverstärker, dann wiederholt sich die Anbindung der Eingangsleitungen an die Verstärkerausgänge zyklisch. Da nun aber von einer Pegeländerung an einem Verstärkerausgang wieder zwei oder mehr Eingangsleitungen betroffen sind, ist die bereits erwähnte Aufteilung der Summenmatrix in ebenso viele Teilmatrizen vorgesehen. Mit der dadurch bedingten galvanischen Trennung der einander entsprechenden, logisch jedoch wieder verknüpften Summentermleitungen der Teilmatrizen wird erreicht, daß der Fehler eines mit der einen Eingangsleitung verbundenen Koppelelements nicht durch die einwandfreie Funktion eines mit der parallel gesteuerten anderen Eingangsleitung verbundenen Koppelelements überdeckt wird, wie das bei bei durchgehenden Summentermleitungen der Fall wäre.

Zur Prüfung der Summenmatrix bzw. der Summenteilmatrizen wird an alle Eingänge E1 bis E3 der Logikanordnung ein Pegel im Bereich der normalen binären Signalpegel, vorzugsweise der hohe Signalpegel H angelegt. Am Prüfanschluß PP2 der Summenmatrix ist dann ein entsprechender, vergleichsweise niedriger Pegel, zu messen. Nun wird der Pegel am Eingang eines Verstärkers auf einen im Normalbetrieb verbotenen Wert S mit beispielsweise + 1,5 V erhöht. Der Transistor T1 (vergl. Fig. 3) dieses Verstärkers wird in das Sättigungsgebiet gesteuert und der Eingangspegel S setzt sich, um den Spannungsabfall an der Basis-Kollektor-Diode verringert, auf die Basis des Transistors T2 durch. Damit wird schließlich auch der Pegel am Prüfanschluß PP2 angehoben. Letzteres trifft jedoch nicht zu, wenn eines der Koppelelemente, die mit den Eingangsleitungen mit erhöhtem Pegel verbunden sind, einen Fehler aufweist. Der Pegel S wird nacheinander an alle Variableneingänge E1 bis E3 angelegt.

## Patentansprüche

1. Programmierbare Logikanordnung in ECL-Technik mit einer Produktmatrix (PM), bei der alle an die Ausgänge von Eingangsverstärkern (V1 bis V3) angeschlossenen Eingangsleitungen (L1 bis L3, L1* bis L3*) für wahre und invertierte Matrixsteuersignale mittels über trennbare Verbindungen angeschlossenen, nicht invertierenden Koppelelementen (K) mit allen Produkttermleitungen (P1 bis P6) verknüpft sind und alle Produkttermleitungen mit den Eingängen von Produktterminvertern (IV1 bis IV6) verbunden sind und mit einer Summenmatrix (SM), bei der die Ausgänge der Produktterminverter mit den Eingangsleitungen (P1* bis P6*) der Summenmatrix verbunden sind und die Eingangsleitungen mittels über trennbare Verbindungen angeschlossenen, nichtinvertierenden Koppelelementen mit allen Summentermleitungen (S11 bis S14, S21 bis S24) verknüpft sind und alle Summentermleitungen mit den Eingängen von invertierenden Ausgangsverstärkern (AV1 bis AV4) verbunden sind, deren Ausgänge (A1 bis A4) die Ausgänge der Logikanordnung bilden, gekennzeichnet durch die Kombination folgender Merkmale :

a) An alle Produkttermleitungen (P1 bis P6) sind die Kathoden von Dioden (DP1 bis DP6) angeschlossen, deren Anoden mit einem gemeinsamen Produktmatrix-Prüfanschluß (PP1) verbunden sind,

b) die Summenmatrix ist in die kleinstmögliche Zahl von Summenteilmatrizen (SM1, SM2) mit getrennten Summentermleitungen (S11 bis S14, S21 bis S24) aufgeteilt, wobei jede Summenteilmatrix (SM1, SM2) höchstens so viele Eingangsleitungen (P1* bis P3*, P4* bis P6*) aufweisen darf als Eingangsverstärker (V1 bis V3) vorhanden sind,

c) die einander entsprechenden Summentermleitungen (S11 bis S24) von mehreren Summenteilmatrizen (SM1, SM2) sind gemäß den innerhalb der Summenteilmatrizen (SM1, SM2) gültigen Verknüpfungsfunktionen durch zusätzliche Verknüpfungsglieder (G1 bis G4) logisch verknüpft,

d) zwischen den invertierenden Ausgängen der Eingangsverstärker (V1 bis V3) und den Eingangsleitungen (P1* bis P6*) der Summenmatrix (SM) bzw. der Summenteilmatrizen (SM1, SM2) sind Dioden (D1 bis D6) in Durchlaßrichtung angeordnet, derart, daß alle Eingangsleitungen (P1* bis P6*) der Summenmatrix, bei mehreren Summenteilmatrizen durch eine zyklisch wiederholte Einbeziehung der invertierenden Ausgänge der Eingangsverstärker (V1 bis V3) erfaßt sind und jede Eingangsleitung (P1* bis P6*) über eine der Dioden (D1 bis D6) nur mit einem Ausgang eines Eingangsverstärkers (V1 bis V3) verbunden ist und

e) an alle Summentermleitungen (S11 bis S24) sind die Kathoden von Dioden (DS11 bis DS24) angeschlossen, deren Anoden mit einem gemeinsamen Summenmatrix-Prüfanschluß (PP2) verbunden sind.

2. Verfahren zur Prüfung der Produktmatrix der programmierbaren Logikanordnung nach Anspruch 1 im nichtprogrammierten Zustand, gekennzeichnet durch folgende Schritte bei ständiger Messung der am Prüfanschluß (PP1) der Produktmatrix (PM) anliegenden Pegels :

a) An alle Eingänge (E1 bis E3) der Logikanordnung wird ein Mittelpegel (M) angelegt, der in der Mitte zwischen dem hohen (H) und dem tiefen (L) Signalpegel der Eingangsvariablen liegt,

b) an die Eingänge (E1 bis E3) wird nacheinander jeweils einzeln der hohe Signalpegel (H) unter Beibehaltung des Mittelpegels (M) an den übrigen Eingängen angelegt,

c) an die Eingänge (E1 bis E3) wird nacheinander jeweils einzeln der tiefe Signalpegel (L) unter Beibehaltung des Mittelpegels (M) an den übrigen Eingängen angelegt und

d) während der Durchführung der Maßnahmen b) und c) wird der Pegel am Prüfanschluß (PP1) fortlaufend gemessen, wobei ein im Vergleich zum Mittelpegel (M) gemessener höherer Pegel die Funktionsfähigkeit der Anordnung kennzeichnet.

3. Verfahren zur Prüfung der Summenmatrix der programmierbaren Logikanordnung nach Anspruch 1 im nichtprogrammierten Zustand, gekennzeichnet durch folgende Schritte bei ständiger Messung des am Prüfanschluß (PP2) der Summenmatrix (SM1, SM2) anliegenden Pegels :

a) An alle Eingänge (E1 bis E3) der Logikanordnung wird der hohe Signalpegel (H) angelegt,

b) an die Eingänge (E1 bis E3) wird nacheinander jeweils einzeln unter Beibehaltung des hohen Signalpegels (H) an den übrigen Eingängen ein gegen den hohen Signalpegel (H) um wenigstens drei Diodenschwellspannungen überhöhter Pegel (S) angelegt und

c) während der Durchführung der Maßnahme b) wird der Pegel am Prüfanschluß (PP2) fortlaufend gemessen, wobei ein im Vergleich zu dem Pegel, der sich nach Maßnahme a) am Prüfanschluß (PP2) einstellt, gemessener höherer Pegel die Funktionsfähigkeit der Anordnung kennzeichnet.

**Claims**

1. A programmable logic arrangement in ECL-technology, with a product matrix (PM) where all the input lines are connected to the outputs of input amplifiers (V1 to V3) for true and inverted matrix control signals, logic-linked to all the product term lines (P1 to P6) by means of non-inverting coupling elements (K) connected via non-permanent connections, and all the product term lines are connected to the inputs of product term inverters (IV1 to IV6), and with a sum matrix (SM) where the outputs of the product term inverters are connected to the input lines (P1* to P6*) of the sum matrix and the input lines are logic-linked to all the sum term lines (S11 to S14, S21 to S24) by means of non-inverting coupling elements connected via non-permanent connections, and all the sum term lines are connected to the inputs of inverting output amplifiers (AV1 to AV4) whose outputs (A1 to A4) form the arrangements of the logic arrangement, characterised by the combination of the following features :

a) all the product term lines (P1 to P6) are connected to the cathodes of diodes (DP1 to DP6), the anodes of which are connected to a common product matrix test terminal (PP1) ;

b) the sum matrix is divided into the smallest possible number of sum sub-matrices (SM1, SM2) with separate sum term lines (S11 to S14, S21 to S24), where each sum sub-matrix (SM1, SM2) can at the maximum comprise as many input lines (P1* to P3*, P4* to P6*) as there are input amplifiers (V1 to V3) provided ;

c) the sum term lines (S11 to S24), of a plurality of sum sub-matrices (SM1, SM2) which correspond to one another are logic-linked by additional logic-linking elements (G1 to G4) in accordance with the logic-linking functions which apply within the sum sub-matrices (SM1, SM2) ;

d) between the inverting outputs of the input amplifiers (V1 to V3) and the input lines (P1* to P6*) of the sum matrix (SM) or the sum sub-matrices (SM1, SM2) diodes (D1 to D6) are arranged in the forwards direction in such manner that, in the case of a plurality of sum sub-matrices, all the input lines (P1* to P6*) of the sum matrix are dealt with by a cyclically-repeated inclusion of the inverting outputs of the input amplifiers (V1 to V3) and each input line (P1* to P6*) is connected only to one output of an input amplifier (V1 to V3) via one of the diodes (D1 to D6) ; and

e) all the sum term lines (S11 to S24) are connected to the cathodes of diodes (DS11 to DS24), the anodes of which are connected to a common sum matrix test terminal (PP2).

2. A method of testing the product matrix of the programmable logic arrangement claimed in Claim 1, in the non-programmed state, characterised by the following steps during the continuous measurement of the level connected to the test terminal (PP1) of the product matrix (PM) :

a) all the inputs (E1 to E3) of the logic arrangement are connected to a mean level (M) mid-way between the high (H) and the low (L) signal level of the input variables ;

b) the inputs (E1 to E3) are each consecutively and individually connected to the high signal level (H), whilst the mean level (M) is maintained at the other inputs ;

c) the inputs (E1 to E3) are each consecutively and individually connected to the low signal level (L), whilst the mean level (M) is maintained at the other inputs ; and

d) during the execution of measures b) and c) the level at the test terminal (PP1) is continuously measured, where a higher measured level than the mean level (M) characterises the functioning capacity of the arrangement.

3. A method for testing the sum matrix of the programmable logic arrangement claimed in Claim 1 in the non-programmed state, characterised by the following steps during the continuous measurement of the level prevailing at the test terminal (PP2) of the sum matrix (SM1, SM2) :

a) the high signal level (H) is connected to all the inputs (E1 to E3) of the logic arrangement ;

b) whilst the high signal level (H) is maintained at the other inputs, the inputs (E1 to E3) are each consecutively and individually connected to a level (S) at least three diode threshold voltages higher than the high signal level (H) ; and

c) during the execution of measure b) the level at the test terminal (PP2) is continuously measured, where a higher level, measured in comparison to the level which prevails at the test terminal (PP2) in accordance with measure a), characterises the functioning capacity of the arrangement.

**Revendications**

1. Réseau logique programmable réalisé selon la technique ECL, comportant une matrice de produit (PM) dans laquelle toutes les lignes d'entrée, qui sont raccordées aux sorties d'amplificateurs d'entrée (V1 à V3) et destinées à véhiculer des signaux de commande de matrice vrais et inversés, sont combinées à toutes les lignes (P1 à P6) véhiculant les termes du produit, au moyen d'éléments de couplage non inverseurs (K) raccordés par l'intermédiaire de liaisons détachables, et toutes les lignes de transmission des termes du produit sont reliées aux entrées d'inverseurs (IV1 à IV6) de transmission des termes du produit, et comportant une matrice d'addition (SM), et dans lequel les sorties des inverseurs des termes des produits (P1* à P6*) de la matrice d'addition et les lignes d'entrée sont combinées à toutes les lignes (S11 à S14, S21 à S24), véhiculant les termes de la somme, au moyen d'éléments de couplage non inverseurs raccordés par l'intermédiaire de liaisons détachables, et toutes les lignes véhiculant les termes de la somme sont reliées aux entrées d'amplificateurs inverseurs de sortie (AV1 à AV4), dont les sorties (A1 à A4) constituent les sorties du réseau logique, caractérisé par la combinaison des moyens suivants :

a) à toutes lignes (P1 à P6) véhiculant les termes du produit se trouvent raccordées les cathodes de diodes (DP1 à DP6), dont les anodes sont reliées à une borne commune (PP1) de contrôle de la matrice de produit,

b) la matrice d'addition est subdivisée en le nombre le plus faible possible de matrices partielles d'addition (SM1, SM2) comportant des lignes séparées (S11 à S14, S21 à S24) véhiculant les termes de la somme, chaque matrice partielle d'addition (SM1, SM2) pouvant comporter au maximum autant de lignes d'entrée (P1* à P3*, P4* à P6*) qu'il existe d'amplificateurs d'entrée (V1 à V3),

c) les lignes (S11 à S24) véhiculant les termes de la somme, qui se correspondent réciproquement, de plusieurs matrices partielles d'addition (SM1, SM2) sont combinées logiquement, conformément aux fonctions de combinaisons valables à l'intérieur des matrices partielles d'addition (SM1, SM2), au moyen de circuits logiques supplémentaires (G1 à G4),

d) des diodes (D1 à D6) sont montées, en étant branchées dans le sens direct, entre les sorties inverseuses des amplificateurs d'entrée (V1 à V3) et les lignes d'entrée (P1* à P6*) de la matrice d'addition (SM) ou des matrices partielles d'addition (SM1, SM2), de telle sorte que toutes les lignes d'entrée (P1* à P6*) de la matrice d'addition sont détectées, dans le cas de plusieurs matrices partielles d'addition par une insertion, répétée de façon cyclique des sorties inverseuses des amplificateurs d'entrée (V1 et V3) et que chaque ligne d'entrée (P1* à P6*) est reliée par l'intermédiaire de l'une des diodes (D1 à D6) uniquement à une sortie d'un amplificateur d'entrée (V1 à V3), et

e) à toutes les lignes (S11 à S24) véhiculant les termes de la somme se trouvent raccordées les cathodes de diodes (DS11 à DS24), dont les anodes sont reliées à une borne commune (PP2) de contrôle de la matrice d'addition.

2. Procédé pour contrôler la matrice d'un produit du réseau logique programmable selon la revendication 1, à l'état non programmé, caractérisé par les phases opératoires suivantes lors de la mesure continue des niveaux appliqués à la borne de contrôle (PP1) de la matrice de produit (PM) :

a) à toutes les entrées (E1 à E3) du circuit logique se trouve appliqué un niveau intermédiaire (M) qui est situé à mi-chemin entre le niveau de signal haut (H) et le niveau de signal bas (L) des variables d'entrée,

b) le niveau de signal haut (H) est appliqué successivement et séparément aux entrées (E1 et E3), tandis que le niveau intermédiaire (M) est maintenu sur les autres entrées,

c) le niveau de signal bas (L) est appliqué successivement et séparément aux entrées (E1 à E3) tout en maintenant le niveau intermédiaire (M) au niveau des autres entrées, et

d) pendant l'exécution des phases opératoires b) et c), on mesure en permanence le niveau présent sur la borne de contrôle (PP1), auquel cas un niveau haut mesuré par rapport au niveau intermédiaire (M) caractérise l'aptitude au fonctionnement du réseau.

3. Procédé pour contrôler la matrice de somme du réseau logique programmable suivant la revendication 1, à l'état non programmé, caractérisé par les phases opératoires suivantes lors de la mesure continue du niveau appliqué sur la borne de contrôle (PP2) de la matrice d'addition (SM1, SM2) :

a) le niveau de signal haut (H) est appliqué à toutes les entrées (E1 à E3) du circuit logique.

b) un niveau (S), qui augmenté d'au moins trois tensions de seuil de diodes par rapport au niveau de signal haut (H), est appliqué successivement et séparément aux entrées (E1 à E3) tout en maintenant le niveau de signal haut (H) appliqué aux autres entrées,

c) pendant l'exécution de la phase opératoire (b) on mesure en permanence le niveau présent sur la borne de contrôle (PP1), auquel cas un niveau haut mesuré par rapport au niveau qui s'établit conformément à la phase opératoire a) sur la borne de contrôle (PP2), caractérise l'aptitude au fonctionnement du réseau.

FIG 1

## FIG 2

## FIG 3